Europäisches Patentamt

**European Patent Office**

**Office européen des brevets**

(11) Publication number: **0 026 629**

**B1**

(12) # EUROPEAN PATENT SPECIFICATION

(45) Date of publication of patent specification: **10.12.86**

(51) Int. Cl.⁴: **H 01 L 31/10,** H 01 L 31/18

(21) Application number: **80303334.9**

(22) Date of filing: **24.09.80**

(54) **Methods of manufacturing semiconductor devices, for example photodiodes, and devices so manufactured.**

(30) Priority: **28.09.79 JP 125047/79**
**28.09.79 JP 125048/79**

(43) Date of publication of application:
**08.04.81 Bulletin 81/14**

(45) Publication of the grant of the patent:
**10.12.86 Bulletin 86/50**

(84) Designated Contracting States:
**DE FR GB**

(56) References cited:
**US-A-3 457 409**

**APPLIED PHYSICS LETTERS, vol. 34, no. 9, 1st May 1979, pages 591-593, New York (USA); M. FENG et al.: "Be-implanted 1.3-mum InGaAsP avalanche photodetectors".**

**APPLIED PHYSICS LETTERS, vol. 33, no. 11, December 1978, pages 920-922, New York (USA); H.D. LAW et al.: "Ion-implanted InGaAsP avalanche photodiode".**

(73) Proprietor: **FUJITSU LIMITED**
**1015, Kamikodanaka Nakahara-ku**
**Kawasaki-shi Kanagawa 211 (JP)**

(72) Inventor: **Kagawa, Shuzo**
**1-16-401, Nijigaoka 3-chome Tama-ku**
**Kawasaki-shi Kanagawa 215 (JP)**
Inventor: **Shirai, Tatsunori**
**c/o Fujitsu-No. 3-Fujigaokaryo 2-1 Fujigaoka**
**Midori-ku Yokohama-shi Kanagawa 227 (JP)**
Inventor: **Kaneda, Takao**
**1380-A405 Kamikodanaka Nakahara-ku**
**Kawasaki-shi kanagawa 211 (JP)**
Inventor: **Baba, Yasuo**
**1494 Kamikodanaka Nakahara-ku**
**Kawasaki-shi Kanagawa 211 (JP)**

(74) Representative: **Bedggood, Guy Stuart et al**
**Haseltine Lake & Co. Hazlitt House 28**
**Southampton Buildings Chancery Lane**
**London WC2A 1AT (GB)**

Courier Press, Leamington Spa, England.

## Description

This invention relates to methods of manufacturing semiconductor devices, for example photodiodes, and devices so manufactured.

In the art to which this invention pertains, it is generally known and practised to introduce p-type dopants such as boron (B), indium (In) or zinc (Zn) into a semiconductor wafer which already has a background concentration of n-type impurities. In the case of boron, for example, its diffusion coefficient is relatively small, so that a subsequent heat treatment at high temperature for a long period of time is necessary in order to obtain a deep lying diffusion thereof: a heat treatment of the kind just described has adverse effects on the semiconductor wafer resulting in deficiencies in the crystal structure at an interface between an insulating film, such as a silicon dioxide film, formed for masking impurities over part of the surface of a germanium substrate, for example, and the bulk of the substrate. Such heat treatment also results in thermal deformation of the germanium wafer. Both effects are due to difference in thermal expansion coefficients of the insulating film and the bulk.

The problems which can arise may be illustrated by reference to the manufacture of an avalanche photodiode (APD). In the manufacture of an APD it is also generally known and practiced to form guard rings to improve breakdown voltage characteristics. It is necessary to obtain a substantial diffusion depth and a graded p-n junction to maintain sufficient withstand voltage characteristics at the p-n junction at which light is irradiated. As can be inferred from the above boron can only be diffused to a shallow depth and the resulting p-n junction is more like an abrupt step junction than a graded junction, so that withstand voltage characteristics with guard rings formed by boron diffusion may not be as good as is desired.

Thus, effort has been devoted to finding a p-type impurity material which can be diffused sufficiently deeply into a germanium substrate to produce a graded junction and which exhibits high withstand voltage characteristics.

Historically, silicon was first used to make photodiodes for use in the field of light communication systems using optical fibres. Originally the 0.8 µm band was sufficient for the purposes of light communication systems. However, as the wavelength of light used in such communications systems became greater than 1.0 µm, for reducing transmission loss in the fibres, it was found that silicon is unable to respond to light of such wavelengths whereas germanium can respond to light having a wavelength in the range of 1.5 µm. Thus, the potential utility of germanium in the field of light communication came to the attention of researches in the art. However, it has been generally believed that established techniques for manufacturing silicon photodiodes cannot be applied to germanium because, whereas p-type layers can easily be formed into a silicon bulk by diffusion of boron for example, boron could not be used for deep diffusion to form p-type layers in a germanium bulk.

It has been known that beryllium, when diffused into germanium at high temperature, forms a p-type layer. The oxide of beryllium is toxic: the utility of beryllium as a p-type dopant has received at most only limited consideration in practice. Further, Diffusion in Semiconductors by B. L. Sharma, Trans Tech Publication of Clausthal-Zellerfeld, Germany, reports, at P. 107, that the solid solibility of beryllium in germanium is $4 \times 10^{16}$ cm$^{-3}$ at a maximum temperature of 920°C. The same literature also reports, at page 89, that the diffusion coefficient of beryllium is $8.9 \times 10^{-13}$ cm$^2$/sec., a value substantially equal to that of zinc or boron, also appearing therein. This means that beryllium should suffer the same problems as boron and the attention of researchers in this art has been diverted away from the possibility of utilising beryllium as a p-type diffusant for germanium.

U.S. Patent No. 3,457,409 discloses high purity bulk germanium doped throughout with beryllium in concentrations of from $1 \times 10^{15}$ to $2 \times 10^{16}$ atoms of beryllium per cm$^3$ of germanium. The doping is achieved by dropping a pellet of beryllium into molten germanium.

The general trend has been to seek a suitable p-type diffusant in group III of the periodic table, and an n-type dopant in group V. Although Zn is in group II, researchers have neglected to look into elements in group II in their efforts to find a suitable p-type dopant to be diffused into germanium, because heat treatment at high temperature and at length is necessary with zinc.

According to the present invention there is provided a method of manufacturing a semiconductor device, characterised in that the method comprises steps of:

implanting ions of beryllium into a germanium substrate; and

heat treating the germanium substrate at a temperature in the range 400°C to 700°C, to diffuse the beryllium introduced into the substrate by ion implantation, to form a p-type region in the substrate;

the amount of beryllium introduced into the substrate by ion implantation being such that the concentration of beryllium at the surface of the substrate in the p-type region is $10^{17}$ cm$^{-3}$ or more.

The present invention originates from an appraisal of beryllium as a p-type dopant in relation to germanium, and experiments were conducted to implant ions of beryllium into a bulk of germanium. A study of the impurity profile obtained with implanted beryllium has disclosed that, quite contrary to the old belief, the profile obtained by the implantation of beryllium ions is different from the profile of known impurities such as boron.

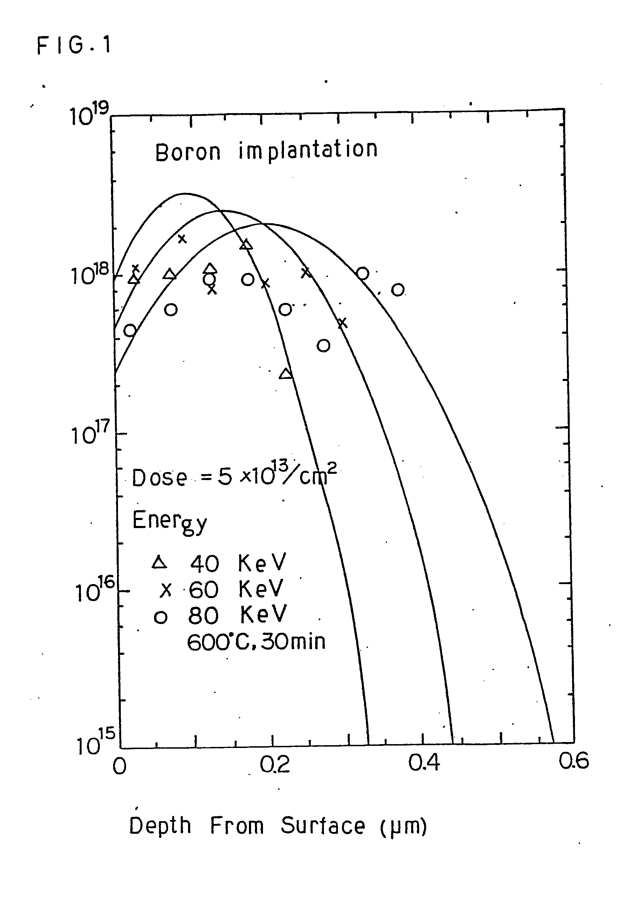

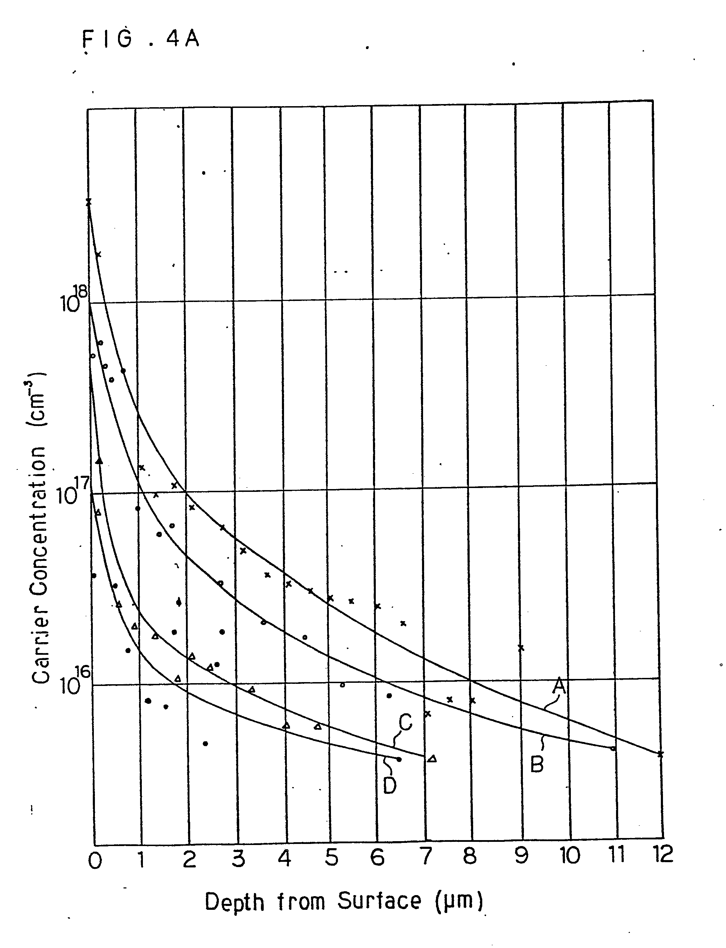

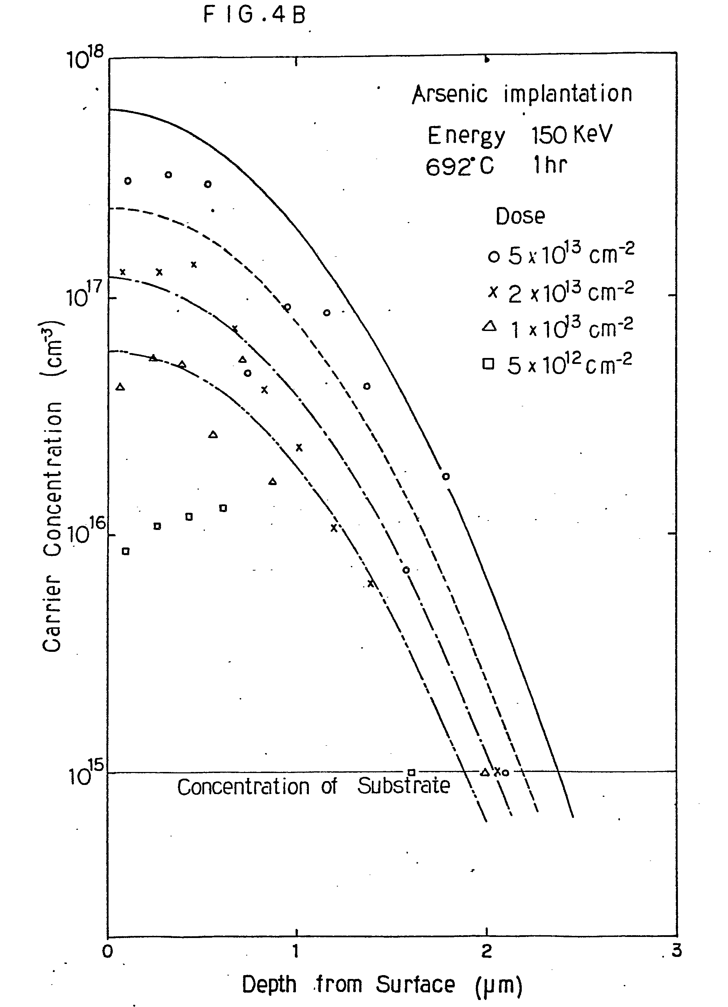

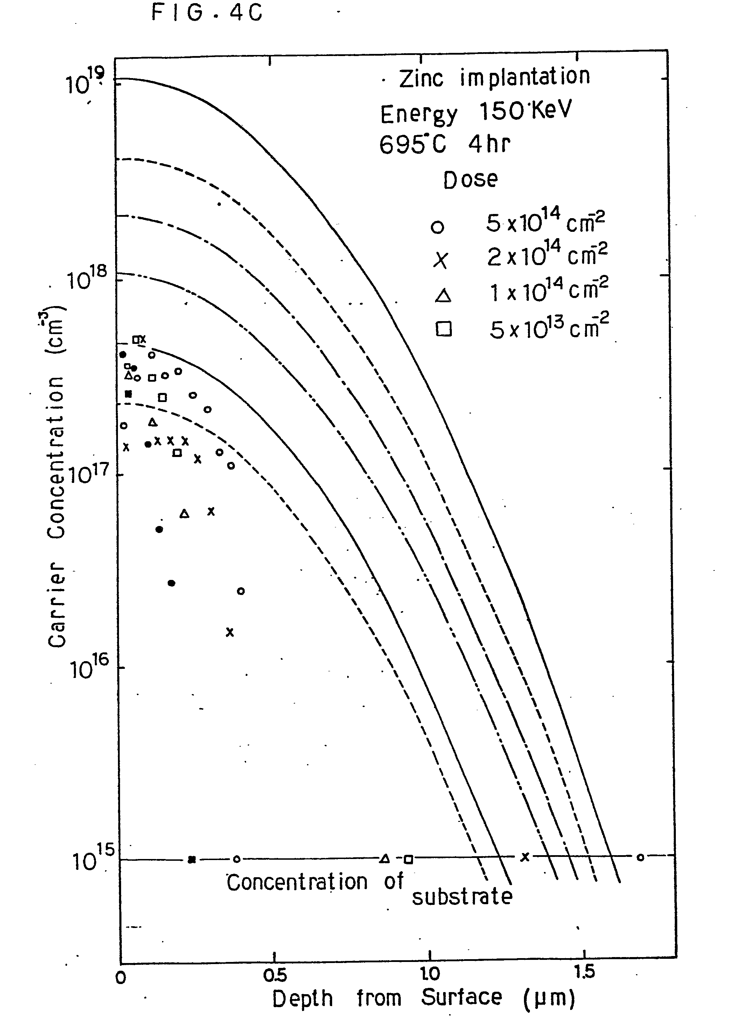

The profile of boron impurities, for example, in germanium bulk, in terms of impurity concentration at different distances from the surface of the germanium bulk has a high impurity concentration plateau as illustrated in Figure 1 of the accompanying drawings, which is a graph in which depth (in µm) from the surface of the germanium bulk is plotted against impurity concentration (cm$^{-3}$). However, the inventors have shown that in the case of beryllium, a curve tracing values of concentration against distance from the surface of a germanium bulk falls gradually to low concentration levels as will be described in more detail hereafter.

As to the diffusion depth achieved when an ion implantation technique is used a much deeper diffusion layer was found to be obtained with beryllium as compared to the diffusion depth of boron, which is in the order of 0.6 µm.

For example, with a germanium wafer heat treated at 640° for one hour after beryllium ion implantation the observed diffusion depth was in the order of 10 µm. Furthermore, it has been found through experiments that heat treatment in the range of 400°C is sufficient to activate beryllium at or near the surface of a germanium bulk. In addition, the practicable maximum concentration of active beryllium atoms in germanium bulk was found to be much higher than 10$^{17}$ cm$^{-3}$ in contrast to the solid solubility of 4×10$^{16}$ cm$^{-3}$ as taught by the prior art literature cited above.

A germanium bulk into which a p-type diffusion layer has been diffused by implantation of beryllium ions and subsequent heat treatment has been found to be especially suitable for the formation of an avalanche photodiode.

Taking an extrinsic pn-junction silicon photodiode as an example, when photons having an energy larger than that of the silicon energy gap are absorbed in the device, hole-electron pairs are generated, as is generally known. The depletion region is substantially void of free current carriers, so that a main electric field exists within the depletion region. Hole-electon pairs induced by photons are separated and drawn out by the equivalent depletion region voltage and the applied reverse bias to generate a photocurrent with an avalanche multiplication effect.

In such an avalanche photodiode one of the techniclal problems has been to reduce noise and dark current the main cause of which is diffusion of minority carriers, generated near the pn-junction, toward the depletion region. In order to minimize the dark current, n-type channel stoppers and/or islands have been formed into the bulk of the silicon substrate to restrict the diffusion of minority carriers to the depletion region.

In an embodiment of the present invention, p-type channel stoppers and/or islands are formed in the bulk of a germanium substrate for the same purpose. The method of ion implantation of beryllium into a germanium substrate as explained above has been found to be effective in obtaining sufficient diffusion depth of beryllium to suppress dark current substantially.

In an embodiment of the present invention, ions of beryllium are implanted into the bulk of a germanium substrate in order to form a deep lying p-type impurity layer in the substrate at a relatively low temperature. In a photodiode device the method can be used to form a deep lying layer which will suppress dark current. In can alternatively or in addition improve breakdown voltage characteristics of semiconductor device.

In more detailed applications the invention can provide for the formation of p-type channel stopper regions by implanting ions of beryllium into a germanium substrate, in a method of manufacturing a semiconductor device wherein selectively p-type channel stopper regions are selectively formed and an n-type active region which is isolated from the channel stopper regions is formed in the bulk of the substrate and is surrounded by the channel stopper regions.

The present invention can provide for the formation of p-type guard ring regions by ion implantation of beryllium into a germanium substrate in a method of manufacturing a semiconductor device wherein a relatively shallow p-type active region is formed at one part of an n-type germanium substrate and p-type guard ring regions are formed around the periphery of the p-type active region in such a manner that the guard ring regions overlap the p-type active region.

The present invention can provide for the formation of a p-type region by implanting ions of beryllium into a germanium substrate in a method of manufacturing a semiconductor substrate wherin a p-type region is formed at one part of an n-type germanium substrate, and n-type region is formed within the p-type region.

Reference is made, by way of example, to the accompanying drawings, in which:—

Figure 1, as mentioned above, is a graphical illustration of the relationship between carrier concentration and the distance from the surface of a germanium substrate when ions of boron are implanted into the substrate and annealed thereafter,

Figures 2 and 3 are respective cross-sectional views of germanium photodiodes made in accordance with previous proposals,

Figures 4A, 4B, and 4C are respective graphs, similar to that of Figure 1, relating respectively to the implantation of Be, As and Zn,

Figure 5A to 5F are respective cross-sectional views illustrating a process wherein a method of manufacturing a germanium photodiode according to the present invention is effected,

Figure 5G is a graphical illustration of dark current level in a germanium substrate with and without channel stopper regions respectively, and

Figures 6A to 6F and Figures 7A to 7G are respective cross-sectional views, Figure 6A to 6F illustrating another process wherein a method embodying this invention is effected, and Figures 7A to 7G illustrating a further such process.

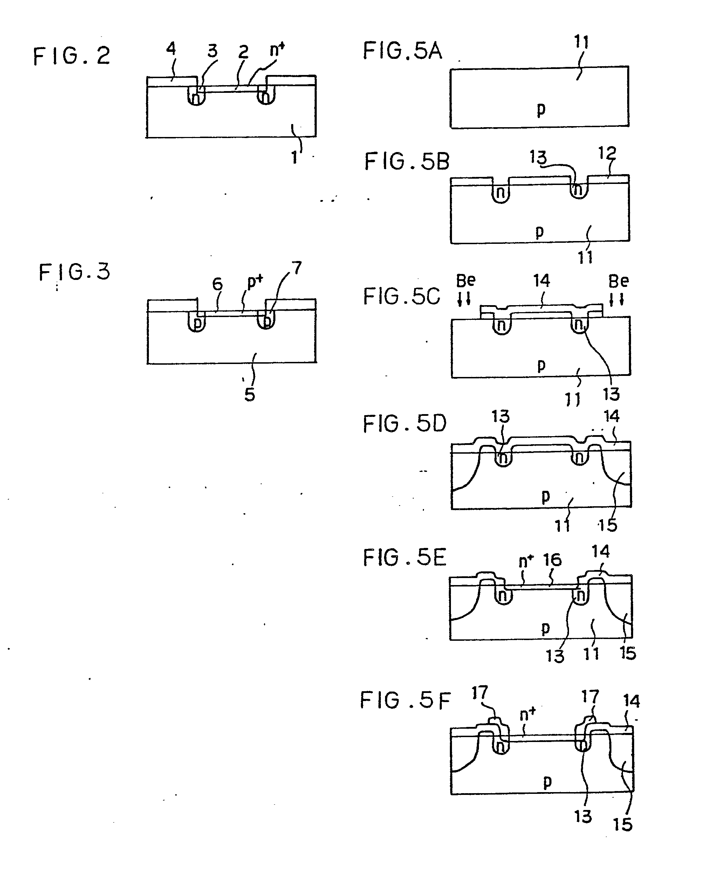

A previously proposed germanium photodiode is illustrated in Figure 2 in cross-section. An $n^+$-type layer 2 is formed by diffusion of high concentration of impurities such as arsenic into an extrinsic p-type germanium substrate 1, then n-type guard ring regions 3 are formed as shown by diffusion of antimony or arsenic according to a conventional technique. The surface of the germanium substrate 1 is covered by a film 4 of silicon dioxide ($SiO_2$) except over that part in which $n^+$-type layer 2 is formed. If a photodiode is made of this germanium substrate, a diffusion current caused by diffusion of minority carriers generated within the bulk of the substrate towards the depletion region at the p-n junction is larger than that appearing at any pn-junction silicon photodiode. Dark current is caused mainly by such diffusion current at room temperature, and the germanium photodiode illustrated was known to have an inherent weakness in that dark current generated therein is substantial. Moreover, in the photodiode shown in Figure 2, an n-type inversion layer is created on the surface of p-type germanium substrate 1 which is in contact with the $SiO_2$ layer 2 due to the effect of positive electric charge within the layer 2. Because of this, the depletion region at the p-n junction extends horizontally along the inversion layer, which increases the equivalent contact area and consequently the diffusion current and the leakage current at the surface. In spite of these effects, no effective steps to prevent formation of the inversion layer have been taken because it has been believed that there was no way to form a sufficiently deep layer of p-type impurities in the bulk of germanium substrate at low temperature as explained previously.

Figure 3 shows in cross-section another previously proposed germanium photodiode. A $p^+$-type layer 6 is formed on the surface of an extrinsic n-type germanium substrate 5 by implanting ions of boron or indium therein, and zinc is diffused thereafter into the bulk of the substrate by heat treatment of form p-type guard ring regions 7 as shown, by a known technique.

In this case, the diffusion of zinc is effected by heat treatment at a temperature higher than 800°C, and the high temperature affects germanium crystals adversely, tending to increase dark current as described before. In addition, since the diffusion coefficient of zinc is relatively low, the radius of curvature on any section of each guard ring region is small, resulting in concentration of electric field. Further, since the impurity concentration of zinc is relatively high, the depletion region extends mainly in the lateral direction of the n-type germanium substrate 5 which results in a low breakdown voltage. As is generally known, it is desirable to make the effective depletion region as deep as possible in order to maximise quantum efficiency.

In embodiments of the present invention, these problems as experienced in connection with previous proposals are taken into consideration, and the invention provides a method of manufacturing a semiconductor device wherein a deep lying p-type layers are formed in a germanium substrate at low temperature, thereby maintaining dark current at low level while improving breakdown voltage characteristics.

As has been outlined previously, in a method enbodying the present invention p-type impurity layers are formed by implanting ions of beryllium into a germanium substrate, and by means of such a method p-type channel stopper regions can be formed in a p-type germanium substrate, or p-type guard ring layers can be formed in an n-type germanium substrate.

Thus, a germanium photodiode which is especially suitable as a detector in a 1 μm band light communication system can be manufactured in accordance with the present invention.

The inventors implanted ions of various impurity materials into germanium substrates, examined the results thereof and found the relationships between the concentration of carriers due to ion implantation of beryllium and the distance from the surface of a germanium substrate as shown graphically in Figure 4A. Curves A and B relate respectively to the relationships when applied acceleration voltage is 100 KeV with doses in the order of $5 \times 10^{14}$ cm$^{-2}$ (Curve A) and $2 \times 10^{14}$ cm$^{-2}$ (curve B) respectively.

Curves C and D illustrate respectively the relationships when applied acceleration voltage is 50 KeV with doses in the range of $1 \times 10^{14}$ cm$^{-2}$ (curve C) and $5 \times 10^{13}$ cm$^{-2}$ (curve D) respectively. (At room temperature, the concentration of carriers may be approximated to the concentration of impurities although the former shows a value only slightly less than the latter). Concentration of impurities in the germanium substrate was initially $4 \times 10^{15}$ cm$^{-3}$ throughout, and heat treatment at 646°C was carried out for one hour. Examination of the carrier concentration relationship appearing in Figure 4A reveals that, in the case of curve A there is a high concentration of carriers due to beryllium, the concentration exceeding a value of $10^{18}$ cm$^{-3}$, near the surface, and that the concentration decreases abruptly in the direction of depth of the substrate, and that thereafter a region of low concentration extends approximately 12 μm deep into the substrate. Other curves B, C and D show substantially same type of concentration distribution. The result clearly shows that the concentration of active atoms of beryllium for providing conductive carriers in germanium is more than $10^{18}$ cm$^{-3}$, a value higher than the maximum solid solubility value of $4 \times 10^{16}$ cm$^{-3}$ given in the above cited Trans Tech publication.

In contrast, when ions of arsenic (As) were implanted into a germanium substrate, with an acceleration voltage of 150 KeV, a dosage in the order of $5 \times 10^{13}$ cm$^{-2}$ with subsequent heat treatment at 692°C for one hour, carrier concentration at the surface of the substrate was approximately $10^{17}$ cm$^{-3}$, and the diffusion depth was approximately of the order of 2 μm as shown

in a graphic illustration of Figure 4B. Ions of zinc (Zn) were implanted into a germanium substrate with an acceleration voltage of 150 KeV, a dosage in the range of $5\times10^{13}$ cm$^{-2}$, to be followed by heat treatment at 695°C for 4 hours. Carrier concentration at the surface was approximately $10^{18}$ cm$^{-3}$, and the diffusion depth was in the range of 1.5 μm as illustrated in Figure 4C.

The data set out above shows that implantation of ions of beryllium into the bulk of a germanium substrate allows low temperature formation of p-type layers in which the concentration profile reaches a high level at the surface of the substrate and in which the region of low concentration extends deep into the substrate from the surface thereof. This is unlike the cases of diffusion by heat treatment of arsenic or antimony (Sb) or the case of ion implantation of arsenic or zinc.

According to a method enbodying the present invention, p-type layers can be formed at temperatures less than 700°C, so that an increase in dark current (in a photodiode) due to crystal structures of germanium substrate being adversely affected by heat treatment, can be prevented. Figures 5A to 5F illustrate in respective cross-sectional views steps involved in carrying out a method embodying the present invention to manufacture a germanium photodiode.

A film 12 (Figure 5B) of silicon dioxide (SiO$_2$) is formed, for use as a diffusion mask, in a conventional manner on the surface of an extrinsic p-type germanium substrate 11 (Figure 5A). Windows are opened in the oxide film 12 by a known photoetching technique, and antimony is selectively diffused into the substrate through the windows for 2½ hours at 750°C to form n-type guard ring regions 13 (Figure 5B) The entire surface is then covered with an oxide film 14 by known means, and windows are formed outside (as seen in Figure 5C) the guard ring region 13. Then, ions of beryllium are implanted into the substrate 11 through the windows in film 14 at an acceleration voltage of 100 KeV with a dosage in the range of $2\times10^{14}$ cm$^{-2}$ as in a conventional manner (Figure 5C). In the implantation step the oxide film 14 acts as a mask so that the ions are selectively introduced into the substrate. The substrate is heat treated for one hour at 646°C to cause activation and diffusion of the implanted beryllium atoms to form p-type channel stopper region 15 (Figure 5D). As will be understood from the distribution of carriers due to diffusion of impurity material as illustrated in Figure 4A, beryllium is diffused in such a manner that the substrate is heavily doped, with a beryllium concentration in the order of approximately $10^{18}$ cm$^{-3}$, at or near the surface of the substrate, and in the case of n-type germanium substrate having an initial general impurity concentration of the order of $10^{16}$ cm$^{-3}$, the resultant p-n junction at the depth of approximately 6 μm from the surface was obtained.

Thereafter, oxide film inside (as seen in the Figure) the guard ring region 13 is removed, arsenic is selectively diffused for 18 minutes at 620°C to form a heavily doped n$^+$ type layer 16, 300—400 nm (3,000—4,000Å) thick (Figure 5E). The surface of n$^+$-type layer 16 is where light is to be irradiated and it works as an active region. Then, aluminium (Al) electrode 17 is deposited by evaporation on the surface of guard ring region 13 (Figure 5F). By way of explanation, it should be pointed out that the guard ring region 13 is prepared in order to increase the breakdown voltage in the periphery of n$^+$-type layer 16. An electrode for the p-type germanium substrate 11 is made by bonding a gold plated stem to the bottom of the substrate opposite to the layer 16, but the electrode is not shown in the drawing.

A germanium photodiode manufactured as has been described comprises a p-type germanium substrate 11 on which is formed an n$^+$-type layer 16, with channel stopper region 15 formed by implantation of ions of beryllium, preferably having the diffusion depth of 5 μm or more, or at least a depth greater than that of the n$^+$-type layer 16.

In the germanium photodiode manufactured in accordance with the above embodiment, p-type carrier concentration due to beryllium is high where the channel stopper regions 15 are in contact with the oxide film 14, so that an n-type inversion layer cannot be formed. Because of this, the depletion region does not extend horizontally (as seen in the Figure), which lessens diffusion current and surface leakage current. Further, since p-type channel stopper regions extend deep into the substrate from its surface, there is an increase in size of a region which is more heavily doped than p-type germanium substrate 11. In the heavily doped region, diffusion current due to minority carriers, in this case electrons, decreases, so that diffusion current in the p-type germanium substrate can be held down by p-type channel stopper regions 15; in a previously proposed photodiode devoid of channel stopper regions, dark current in the order of $10^{-6}$A was generated, and dark current in the photodiode manufactured according to this invention was reduced to approximately $10^{-7}$A, which allows a reduction in the minimum level of photosensitivity of the photodiode device.

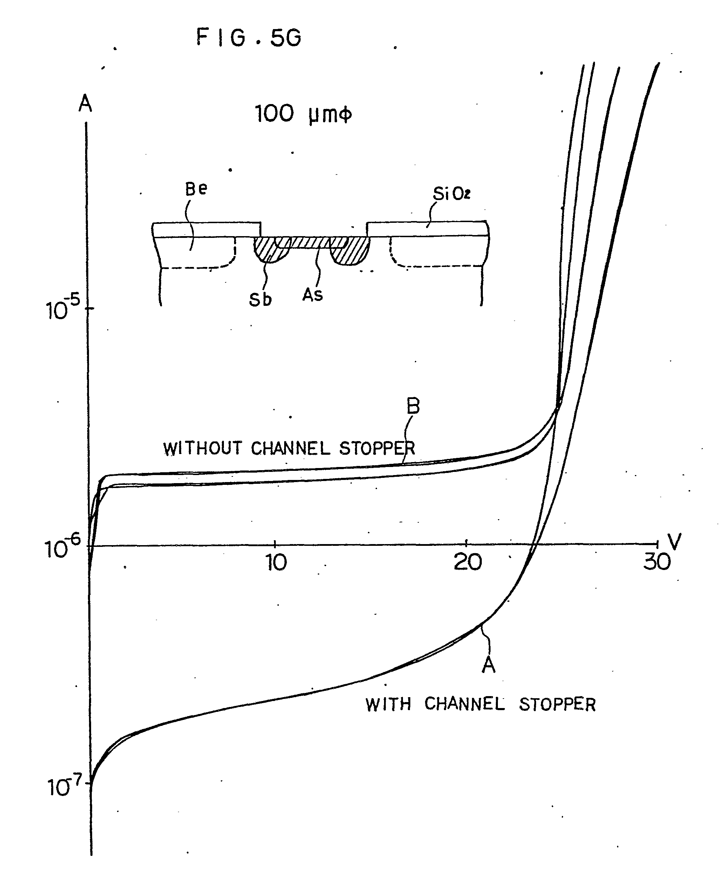

Figure 5G illustrates the technical advantage described above: curves B show the dark current versus voltage relationship for a previously proposed device as illustrated in the upper part of the Figure (but without the channel stopper regions) which has an As-diffused layer of 100 μm diameter. Curves A show the same relationship for a device manufactured according to the present invention (with the channel stopper regions) of the same dimension. These curves illustrate the difference between dark currents in the previously proposed device and the device manufactured in accordance with the invention as just described.

In the manufacturing steps shown in Figures 5A to 5F, heat treatment of implanted beryllium (Figure 5D) and formation of n$^+$-type layer 16 by diffusion of arsenic by heat treatment (Figure 5E) may be carried out simultaneously.

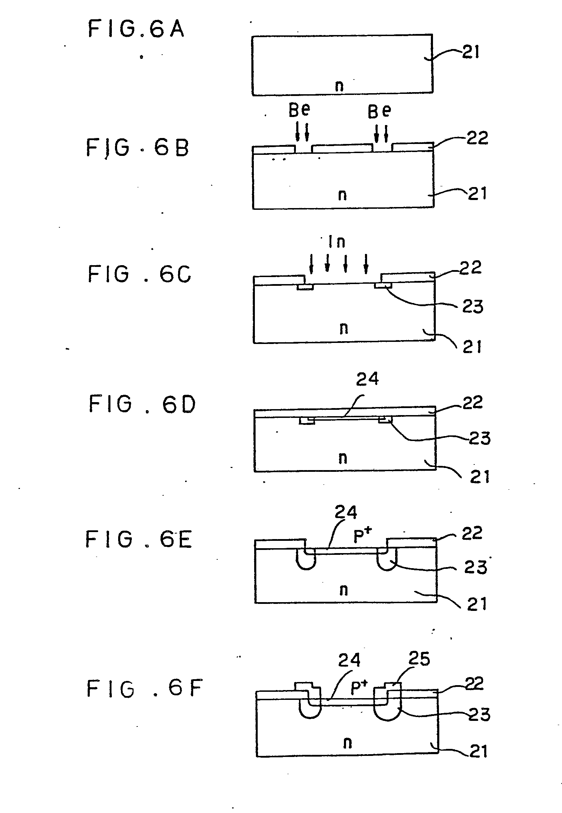

Next, another method of manufacturing a germanium photodiode embodying the present invention will be described with reference to Figure 6A to 6F.

A film 22 (Figure 6B) of silicon dioxide is caused to cover the surface of an extrinsic n-type germanium substrate 21 (Figure 6A), windows are next opened through the oxide film 22 by a conventional photo-etching technique to provide a mask for implantation of ions of beryllium at an acceleration voltage of 50 KeV, with a dosage in the order of $1\times10^{14}$ cm$^{-2}$ (Figure 6B) to form p-type guard ring region 23 (Figure 6C). A window is further formed through the oxide film 22, after the implantation process, in a known manner to provide another mask for implantation of ions of indium (In) at an acceleration voltage of 90 KeV, with a dosage in the range $2\times10^{-13}$ cm$^{-2}$ (Figure 6C) to form a p$^+$-type layer 24 (Figure 6D). After this second implantation process the entire surface is covered with oxide film 22, heat treatment at 646°C is carried out for one hour to form p-type guard ring region 23 approximately 6 μm deep. Simultaneously therewith, p$^+$-type layer 24 is heavily doped, in the order of $10^{18}$ cm$^{-3}$, to a thickness of 100 nm (1000 Å). Next, that part of oxide film 22 on the surface of p$^+$-type layer 24 is removed according to a conventional technique (Figure 6E) to make a window for receiving incident light, and aluminium is deposited by evaporation and selectively etched off in known manner to remain on the surface around the periphery of the p$^+$-type region 24 to form an electrode 25 (Figure 6F).

A germanium photodiode device manufactured as described thus comprises n-type germanium substrate 21 formed with p$^+$-type layer 24 and p-type guard ring region 23.

In a germanium photodiode device formed according to the above embodiment p-type guard ring region 23 can be formed with considerable depth, 5 μm or more, so that the radius of curvature on a section thereof can be made large, increasing the breakdown voltage thereat to a large extent. In addition, carrier concentration of p-type guard ring region 23 is relatively low, $10^{16}$ cm$^{-3}$ near the pn-junction with the n-type substrate. Because of these factors the depletion region extends in the direction of p-type guard ring region 23 and along the depth of n-type germanium substrate 21. By virtue of this, breakdown voltage is increased significantly. Further, since the n-type germanium substrate is formed with a p-type guard ring region and a p$^+$-type layer, the noise level can be reduced compared with a case in which a p-type germanium substrate is used.

In a further embodiment of the present invention an island region of a second conductivity type (n or p) is formed in a germanium substrate of a first conductivity type (p or n), and the island and a region heavily doped with impurity material of the same conductivity type as the substrate which functions as a region to absorb incident light form a pn-junction therebetween to make a photodiode. Steps in a method of manufacturing a photodiode in accordance with such embodiment will now be described with reference to Figures 7A to 7G.

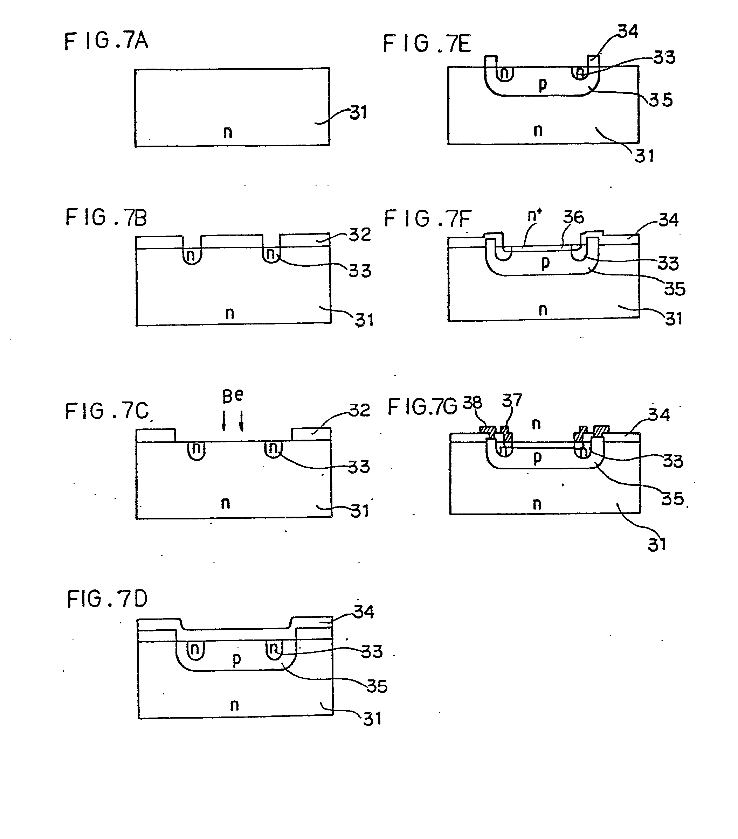

A film 32 of silicon dioxide (SiO$_2$) is caused to cover the surface of a germanium substrate 31 comprising an n-type germanium bulk having an impurity concentration in the order of $4\times10^{15}$ cm$^{-3}$ (Figure 7A). Windows are opened in film 32 by conventional photo-etching, and antimony (Sb) is caused to be diffused, by heat treatment at 750°C for 25 hours, to form n-type guard ring region 33 (figure 7B). Thereafter, one large window is cut through the oxide film 32 as shown in Figure 7C and ions of beryllium are implanted at an acceleration voltage of 100 KeV with a dosage in the range $2\times10^{14}$ cm$^{-2}$. Thereafter the entire surface is covered with an oxide film 34, the substrate is heated to 650°C for one hour for the purpose of activation and diffusion to form a p-type island 35, 12 μm deep and 450 μm in diameter, in the substrate 31 (Figure 7D). Next, oxide film on the surface of the island 35 is removed for opening a window, leaving the oxide film where electrodes are to be formed unremoved in order to lower contact resistance thereat (Figure 7E). Then the surface of the substrate exposed in the window is etched off by about 1 μm. The surface covered by the oxide film is not affected. This process step is carried out for the purpose of removing the heavily doped p-type impurity region formed near the surface of the substrate when ions of beryllium are implanted into the substrate, thereby maintaining the island region 35 lightly doped with impurity material. Thereafter, the surface of the island region is covered with an oxide film, and the part of the film covering the area surrounded by the guard ring region 33 is removed to open window therethrough. Arsenic (As) is diffused through the window at 620°C for 18 minutes to form n$^+$-type layer 36, 300—400 nm (3,000—4,000 Å) thick (Figure 7F). After this process, a contact window is formed through the oxide film 34 and then aluminium (Al) is deposited by evaporation so as to form electrodes 37, 38 for n-type guard ring regions 33 and p-type island region 35.

A germanium photodiode device thus formed comprises an n-type germanium substrate 31 formed with a deep lying lightly doped p-type island region 35 and a heavily doped n$^+$-type layer 36 forming pn-junction with island region 35 and functioning as the light absorbing surface. The island region has a diameter of 200—500 μm for example, and a depth of 5—15 μm.

In this embodiment, the island region is the functioning layer, so that volume of the bulk is effectively reduced. Dark current can be reduced by a factor in the order of $10^{-1}$ or more, thereby allowing minimization of dark current. This means that a reduction of the minimum level of photosensitivity is feasible.

Another advantage of this embodiment is that, since impurity concentration of the island region 35 is low, the depletion region can easily be widened. Because of this, breakdown voltage can be increased. Further, a region in the depletion region that absorbs light is extended, so that quantum efficiency of absorbed light is improved. In addition, the p-type island region is formed at a temperature less than 700°C, so that crystal structures of germanium substrate will not be disturbed. This also contributes to reduction of dark current. In a modification of this embodiment, an n-type island region may be formed in a p-type germanium substrate by implantation of antimony or arsenic ions. For example, an n-type island region approximately 2 µm deep may be formed in a germanium substrate of p-type impurity concentration of the order of $10^{15}$ cm$^{-3}$ by implantation of arsenic ions at acceleration voltage of 150 KeV, and at a dosage in the range of $5 \times 10^{12}$ cm$^{-2}$, followed by heat treatment at 692°C for one hour. The modification will be fabricated by the steps of Figure 7A to 7G with conductivity types reversed.

As has been described, beryllium has been selected as a dopant material to be ion-implanted and diffused into a bulk of a germanium substrate. To do this completely contradicts established beliefs in the art. It is the remarkable discovery by the inventors of the present invention that in spite of reported data which has distracted researchers' attention away from utilising beryllium as a dopant material to be diffused into a germanium substrate, beryllium can provide a practical p-type layer or region in a germanium bulk when coupled with ion implantation technique. The present invention provides for the formation of p-type layers at low temperature, below 700°C, whereby dark current can be reduced in a pn-junction germanium photodiode.

Where a p-type germanium substrate is used, the present invention provides for the formation of p-type channel stopper regions, which serve the purpose of reducing dark current, and where an n-type germanium substrate is used, the present invention provides for the formation of p-type guard ring regions which can increase breakdown voltage.

The present invention further provides for the formation of an island region in a germanium substrate such that conductivity types of the island and the substrate are opposite, whereby a pn-junction germanium photodiode has been obtained which exhibits low dark current and high breakdown voltage.

Thus, in a method of manufacturing a semiconductor device embodying this invention, ions of beryllium are implanted into a germanium substrate to form a layer containing p-type impurity material, thereafter the substrate is heated at a temperature in a range of 400°C to 700°C to diffuse beryllium into the substrate so that concentration of beryllium at the surface of the impurity layer is in the order of $10^{17}$ cm$^{-3}$ or more.

In one embodiment, a p-type stopper is formed locally in a p-type germanium substrate and an n-type active layer is formed in a region surrounded by, and isolated from, the channel stopper region. In another embodiment, a relatively shallow p-type active layer is formed at one part of n-type germanium substrate and a p-type guard ring region is formed surrounding, and partly overlapping the p-type active layer. In another embodiment, a p-type region is formed at one part of an n-type germanium substrate, and an n-type region is formed within said p-type region. In these embodiments, the p-type channel stopper region, the p-type guard ring region and the p-type region are all formed by implanting ions of beryllium into the germanium substrates.

**Claims**

1. A method of manufacturing a semiconductor device, characterised in that the method comprises steps of:

implanting ions of beryllium into a germanium substrate (11, 21, 31); and

heat treating the germanium substrate (11, 21, 31) at a temperature in the range 400°C to 700°C, to diffuse the beryllium introduced into the substrate by ion implantation, to form a p-type region (15, 23, 35) in the substrate;

the amount of beryllium introduced into the substrate by ion implantation being such that the concentration of beryllium at the surface of the substrate (11, 21, 31) in the p-type region (15, 23, 35) is $10^{17}$ cm$^{-3}$ or more.

2. A method as claimed in claim 1, wherein the substrate is a p-type substrate (11), and the said p-type region is selectively and locally formed as a p-type channel stopper region (15) in the substrate (11), and an n-type active layer (16) is formed in a region surrounded by, and isolated from, the channel stopper region (15).

3. A method as claimed in claim 1, wherein the substrate is an n-type substrate (21), and a relatively shallow p-type active layer (24) is formed in the substrate (21), and the said p-type region is a p-type guard ring region (23) formed to surround and partly overlay the p-type active layer (24).

4. A method as claimed in claim 1, wherein the substrate is an n-type substrate (31), and the said p-type region (35) is formed in the substrate (31), and n-type region (36) is formed within the said p-type region (35).

5. A method as claimed in any proceding claim, wherein the semiconductor device is a photodiode.

**Patentansprüche**

1. Verfahren zur Herstellung einer Halbleitervorrichtung, dadurch gekennzeichnet, daß das Verfahren die folgenden Schritte umfaßt:

Implantieren von Ionen aus Beryllium in ein Germaniumsubstrat (11, 21, 31); und

Wärmebehandlung des Germaniumsubstrats (11, 21, 31) bei einer Temperatur in Bereich von 400°C bis 700°C, um das durch Ionenimplantation in das Substrat eingeführte Beryllium zu diffundieren, um einen p-Typ-Bereich (15, 23, 35) in dem Substrat zu bilden;

wobei die Menge von durch Ionenimplantation in das Substrat eingeführtem Beryllium derart ist, daß die Konzentration von Beryllium an der Oberfläche des Substrats (11, 21, 31) in dem p-Typ-Bereich (15, 23, 35) $10^{17} cm^{-3}$ oder größer ist.

2. Verfahren nach Anspruch 1, bei welchem das Substrat ein p-Typ-Substrat (11) ist und der genannte p-Typ-Bereich selektiv und lokal als ein p-Typ-Kanalstopperbereich (15) in dem Substrat (11) gebildet wird, und eine aktive Schicht (16) vom n-Typ in einem Bereich gebildet wird, der von dem Kanalstopperbereich (15) umgeben und von diesem isoliert ist.

3. Verfahren nach Anspruch 1, bei welchem das Substrat ein n-Typ-Substrat (21) ist und eine relativ flache aktive p-Typ-Schicht (24) in dem Substrat (21) gebildet wird und der genannte p-Typ-Bereich ein p-Typ-Schutzringbereich (23) ist, der gebildet ist, um die aktive p-Typ-Schicht (24) zu umgeben und teilweise zu überlappen.

4. Verfahren nach Anspruch 1, bei welchem das Substrat ein n-Typ-Substrat (31) ist und der genannte p-Typ-Bereich (35) in dem Substrat (31) gebildet wird, und ein n-Typ-Bereich (36) innerhalb des genannten p-Typ-Bereichs (35) gebildet wird.

5. Verfahren nach einem der vorhergehenden Ansprüche, bei welchem die Halbleitervorrichtung eine Fotodiode ist.

**Revendications**

1. Procédé de fabrication d'un dispositif semiconducteur, caractérisé en ce qu'il consiste: à implanter des ions de beryllium das un substrat de germanium (11, 21, 31) et à traiter thermiquement le substrat de germanium (11, 21, 31) à une température dans la plage de 400°C à 700°C pour diffuser le beryllium introduit dans le substrat par implantation ionique de manière à former une région de type P (15, 23, 35) dans le substrat, la quantité de beryllium introduite dans le substrat par implantation ionique étant telle que la concentration de beryllium à la surface du substrat (11, 21, 31) dans la région de type P (15, 23, 35) soit $10^{17} cm^{-3}$ ou davantage.

2. Procédé selon la revendication 1, dans lequel le substrat est un substrat de type P (11) et ladite région de type P est formée sélectivement et localement comme une région d'arrêt de canal de type P (15) dans le substrat (11), une couche active de type N (16) est formée dans une région entourée par la région d'arrêt de canal (15) et isolée de cette dernière.

3. Procédé selon la revendication 1, dans lequel le substrat est un substrat de type N (21) et une couche active de type P (24) relativement peu profonde est formée dans le substrat (21), ladite région de type P étant une région d'anneaux de garde (23) de type P formée pour entourer et chevaucher partiellement la couche active de type P (24).

4. Procédé selon la revendication 1, dans lequel le substrat est un substrat de type N (31) et ladite région de type P (35) est formée dans le substrat (31), et une région de type N (36) étant formée dans ladite région de type P (35).

5. Procédé selon l'une quelconque des revendications précédentes dans lequel le dispositif semiconducteur est une photodiode.

FIG.1

Boron implantation

$Dose = 5 \times 10^{13}/cm^2$

Energy

△ 40 KeV
× 60 KeV
○ 80 KeV
600°C, 30min

Depth From Surface (μm)

1

FIG.4A

FIG.4B

Arsenic implantation

Energy    150 KeV
692°C    1hr

Dose
o  $5 \times 10^{13}$ cm$^{-2}$
x  $2 \times 10^{13}$ cm$^{-2}$
△  $1 \times 10^{13}$ cm$^{-2}$
□  $5 \times 10^{12}$ cm$^{-2}$

Carrier Concentration (cm$^{-3}$)

$10^{18}$

$10^{17}$

$10^{16}$

$10^{15}$

Concentration of Substrate

0          1          2          3

Depth from Surface (μm)

FIG.4C

Zinc implantation
Energy 150 KeV
695°C 4hr
Dose

| | |
|---|---|
| ○ | $5 \times 10^{14}$ cm$^{-2}$ |
| × | $2 \times 10^{14}$ cm$^{-2}$ |
| △ | $1 \times 10^{14}$ cm$^{-2}$ |
| □ | $5 \times 10^{13}$ cm$^{-2}$ |

Carrier Concentration (cm$^{-3}$)

Concentration of substrate

Depth from Surface (μm)

FIG.2

FIG.3

FIG.5A

FIG.5B

FIG.5C

FIG.5D

FIG.5E

FIG.5F

FIG.5G

FIG.6A

FIG.6B

FIG.6C

FIG.6D

FIG.6E

FIG.6F

FIG.7A

FIG.7E

FIG.7B

FIG.7F

FIG.7C

FIG.7G

FIG.7D